# EUROPEAN PATENT SPECIFICATION

(11) **EP 4 380 333 B1**
(45) Date of publication and mention of the grant of the patent: **18.02.2026**
(21) Application number: 22211147.8
(22) Date of filing: 02.12.2022
(51) Int. Cl.: H10B 63/00, H10N 70/00, H10N 70/20, H10B 63/10

(54) **TE-CONTAINING OVONIC THRESHOLD SWITCH AND METHOD FOR FORMING THEREOF**
TE-HALTIGER OVONISCHER SCHWELLWERTSCHALTER UND VERFAHREN ZU DESSEN HERSTELLUNG
COMMUTATEUR DE SEUIL OVONIQUE CONTENANT DU TE ET PROCÉDÉ POUR SA FABRICATION

(43) Date of publication of application: 05.06.2024
(73) Proprietor: Imec VZW, 3001 Leuven (BE); Katholieke Universiteit Leuven, 3000 Leuven (BE)
(72) Inventor: CLIMA, Sergiu, 3360 Bierbeek (BE); RAVSHER, Taras, 3001 Heverlee (BE); POURTOIS, Geoffrey, 1495 Villers-la-Ville (BE)
(74) Representative: Winger

(56) References cited:
- US-A1- 2011 141 798
- US-B2- 8 081 506
- VELEA A ET AL: "Te-based chalcogenide materials for selector applications", SCIENTIFIC REPORTS, 14 August 2017 (2017-08-14), pages 1 - 12, XP093039013, DOI: 10.1038/s41598-017-08251-z
- VELEA A ET AL: "Supplementary Information Te-based chalcogenide materials for selector applications", 14 August 2017 (2017-08-14), XP093038904, Retrieved from the Internet <URL:https://static-content.springer.com/esm/art%3A10.1038%2Fs41598-017-08251-z/MediaObjects/41598_2017_8251_MOESM1_ESM.pdf> [retrieved on 20230412]
- KOO Y ET AL: "Te-based amorphous binary OTS device with excellent selector characteristics for x-point memory applications", 2016 IEEE SYMPOSIUM ON VLSI TECHNOLOGY, IEEE, 14 June 2016 (2016-06-14), pages 1 - 2, XP032969373, DOI: 10.1109/VLSIT.2016.7573389
- MATSUBAYASHI D ET AL: "OTS Physics-based Screening for Environment-friendly Selector Materials", 2022 INTERNATIONAL ELECTRON DEVICES MEETING (IEDM), IEEE, 3 December 2022 (2022-12-03), XP034280807, DOI: 10.1109/IEDM45625.2022.10019445

## Description

### Technical field of the invention

The present invention relates to the field of ovonic threshold switches.

### Background of the invention

Resistive memory devices, such as resistive random-access memory (RRAM), magnetoresistive random-access memory (MRAM), or phase-change memory (PCM) devices, can combine the high speed of dynamic random-access memory (DRAM) with the non-volatility and the low cost of flash memory as a so-called storage-class memory (SCM). However, to limit the costs of manufacturing such memory devices, large arrays are preferred. For such an array to function properly, a selector, which is typically a highly non-linear selector element, in series with resistive memory element (sometimes called an "1S1R cell") may be used. Such a selector may suppress the sneak-path leakage current through half-selected cells.

Amorphous, typically chalcogenide-based, ovonic threshold switches (OTS) may be used as the selector. OTSs typically switch from a resistive state to a conductive state (ON state) when a threshold voltage is applied, and returns to the resistive state (OFF state) when the applied voltage drops below a holding voltage, or, equivalently, when a current through the selector drops below a holding current or holding current density. Typically, the holding voltage is lower than the threshold voltage, due to the OTS exhibiting a negative differential resistance resulting in a hysteresis effect for the conductivity of the OTS. Different from phase-change materials for PCM devices, which also exhibit a switching behavior by switching behind, e.g., a crystalline and an amorphous state, the OTS typically remains in the same amorphous glass state while switching. Although the mechanism behind this reversible switching of OTSs is still under debate, an explanation may be found in the metastable formation of newly introduced metavalent bonds under the application of the applied voltage above the threshold voltage, and the termination of these newly introduced metavalent bonds when the applied voltage is below the holding voltage (see, e.g., Noé et al., Toward ultimate nonvolatile resistive memories: The mechanism behind ovonic threshold switching revealed, Science Advances 6 (2020) eaay2830).

The application of OTSs is not limited to selectors. Indeed, instead of being used as a selector, the OTS may itself be used as 2-terminal self-rectifying memory device as well (sometimes called an "1S cell"), i.e., as a memory element itself, which may not require a resistive memory element in series therewith.

Furthermore, apart from applications of OTSs in memory applications, OTSs may be used as electro-static discharge (ESD) devices at the back-end-of-line (BEOL) stage of the manufacturing of a semiconductor device. The ESD device may prevent damage occurring due to, for example, a discharge from an electrostatically charged person or machine to the semiconductor device. When ESD occurs, a large amount of electric charge may flow into the semiconductor device. Thereby, a voltage may be generated inside the semiconductor device, which may cause a dielectric breakdown of the internal circuits of the semiconductor device. A first terminal of the OTS may be connected to the earth and a second terminal of the OTS may be connected to the semiconductor device, so as to provide a conductive path for releasing the generated voltage to prevent dielectric breakdown.

In the state of the art, a wide range of materials for OTSs are available. However, they usually contain the chemical elements arsenic or selenium, which may be toxic. Furthermore, materials for OTSs of the state of the art are often chemically complex.

An OTS having a composition P_{0.09}Si_{0.51}Te_{0.40} has previously been disclosed in the Supplementary Information to Velea et al. "Te-based chalcogenide materials for selector applications." Scientific reports 7 (2017) 8103.

There is thus still a need in the art for devices and methods that address at least some of the above problems.

### Summary of the invention

It is an object of the present invention to provide a good device comprising an ovonic threshold switch. It is a further object of the present invention to provide a good method for forming the ovonic threshold switch.

The above objective is accomplished by a method and apparatus according to the present invention.

It is an advantage of embodiments of the present invention that the ovonic threshold switch may have a strongly nonlinear resistance. It is a further advantage of embodiments of the present invention that the ovonic threshold switch may have a good stability. It is still a further advantage of embodiments of the present invention that the ovonic threshold switch may be straightforwardly manufactured.

It is an advantage of embodiments of the present invention that the ovonic threshold switch may not require the toxic chemical elements such as Se and As generally used in ovonic threshold switches of the state of the art.

In a first aspect, the present invention relates to a device comprising an ovonic threshold switch formed of a mixture consisting of:
at least 0.90 parts by mole of a composition of three chemical elements consisting of:
   from 0.30 to 0.60 parts by mole of Si,
   from 0.05 to 0.40 parts by mole of Te, and
   from 0.15 to 0.50 parts by mole of S, and
at most 0.10 parts by mole of optional other chemical elements different from said three chemical elements,
wherein the parts by mole of the mixture add up to 1.00.

In a second aspect, the present invention relates to a method for forming the device according to embodiments of the first aspect of the present invention, wherein forming the ovonic threshold switch comprises depositing a mixture on a substrate so as to form the mixture consisting of:
at least 0.90 parts by mole of a composition of three chemical elements consisting of:
   from 0.30 to 0.60 parts by mole of Si,
   from 0.05 to 0.40 parts by mole of Te, and
   from 0.15 to 0.50 parts by mole of S, and
at most 0.10 parts by mole of optional other chemical elements different from said three chemical elements,
wherein the parts by mole of the mixture add up to 1.00.

The invention is defined by the appended claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1 is a schematic representation of a perspective view of a memory device in accordance with embodiments of the present invention, wherein the ovonic threshold switch is used as a selector.
FIG. 2 is an exemplary plot of a current flowing through an ovonic threshold switch as a function of applied voltage.
FIG. 3 is a schematic representation of a perspective view of a stack connecting each combination of a row line and a column line of a memory device in accordance with embodiments of the present invention, wherein the ovonic threshold switch is used as a memory element.
FIG. 4A and FIG. 4B are plots of an OTS gauge as a function of an experimental holding current, and an experimental holding voltage for a range of compositions of the state of the art.

### Description of illustrative embodiments

The present invention will be described with respect to particular embodiments of the present invention and with reference to certain drawings, but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment of the present invention" or "an embodiment of the present invention" means that a particular feature, structure or characteristic described in connection with the embodiment is included in at least one embodiment of the present invention. Thus, appearances of the phrases in one embodiment of the present invention" or "in an embodiment of the present invention" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment of the present invention. Thus, the claims following the detailed description are hereby expressly incorporated into this detailed description, with each claim standing on its own as a separate embodiment of this invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

In a first aspect, the present invention relates to a device comprising an ovonic threshold switch, the ovonic threshold switch being formed of a mixture consisting of:
at least 0.90 parts by mole of a composition of three chemical elements consisting of:
   from 0.30 to 0.60 parts by mole of Si,
   from 0.05 to 0.40 parts by mole of Te, and
   from 0.15 to 0.50 parts by mole of S, and
at most 0.10 parts by mole of optional other chemical elements different from said three chemical elements,
wherein the parts by mole of the mixture add up to 1.00.

In embodiments outside the scope of the present invention, the at least 0.90 parts by mole of the composition of three or four chemical elements is at least 0.90 parts by mole of a composition of only three elements consisting of:
from 0.20 to 0.70 parts by mole of Si,
from 0.05 to 0.60 parts by mole of Te, and
from 0.05 to 0.60 parts by mole of S, or P, and
at most 0.10 parts by mole of optional other chemical elements different from said three chemical elements,
wherein the parts by mole of the mixture add up to 1.00.

The other chemical elements different from said three chemical elements cannot include Si or Te but can include S (if S is not one of the three chemical element) or P (if P is not one of the three chemical element). They cannot include S and P together.

In embodiments, each of the three (or four) chemical elements is present in an amount of at least 0.07, preferably at least 0.10, parts by mole.

In embodiments outside the scope of the present invention, the mixture consists of:
at least 0.93 parts by mole of the composition of three or four chemical elements consisting of:
   from 0.20 to 0.60 parts by mole of Si,
   from 0.07 to 0.50 parts by mole of Te, and
   from 0.10 to 0.50 parts by mole of S, P, or a mixture of S and P, and
at most 0.07 parts by mole of the optional other chemical elements different from Si, Te, S, and P,
wherein the parts by mole of the mixture add up to 1.00.

In embodiments outside the scope of the present invention, the mixture consists of:
at least 0.93 parts by mole of the composition of three chemical elements consisting of:
   from 0.20 to 0.60 parts by mole of Si,
   from 0.07 to 0.50 parts by mole of Te, and
   from 0.10 to 0.50 parts by mole of S or P, and
at most 0.07 parts by mole of the optional other chemical elements different from said three chemical elements,
wherein the parts by mole of the mixture add up to 1.00.

In embodiments outside the scope of the present invention, the mixture consists of:
at least 0.90 parts by mole of the composition of three or four chemical elements consisting of:
   from 0.30 to 0.60 parts by mole of Si,
   from 0.05 to 0.40 parts by mole of Te, and
   from 0.15 to 0.50 parts by mole of S, P, or a mixture of S and P, and
at most 0.10 parts by mole of the optional other chemical elements different from Si, Te, S, and P,

In embodiments outside the scope of the present invention, the mixture consists of:
at least 0.90 parts by mole of the composition of three chemical elements consisting of:
   from 0.15 to 0.45 parts by mole of Si,
   from 0.25 to 0.55 parts by mole of Te, and
   from 0.15 to 0.45 parts by mole of P,
   wherein each of the three chemical elements is present in an amount of at least 0.05 parts by mole, and
at most 0.10 parts by mole of the optional other chemical elements different from said three chemical elements,
wherein the parts by mole of the mixture add up to 1.00.

In embodiments outside the scope of the present invention, the mixture consists of:
at least 0.90 parts by mole of the composition of three or four chemical elements consisting of:
   from 0.15 to 0.45 parts by mole of Si,
   from 0.25 to 0.55 parts by mole of Te, and
   from 0.15 to 0.45 parts by mole of S, P, or a mixture of S and P, and
at most 0.05 parts by mole of the optional other chemical elements different from Si, Te, S, and P,

In embodiments outside the scope of the present invention, the mixture consists of:
at least 0.90 parts by mole of the composition of three chemical elements consisting of:
   from 0.25 to 0.55 parts by mole of Si,
   from 0.07 to 0.45 parts by mole of Te, and
   from 0.15 to 0.45 parts by mole of S or P, and
at most 0.10 parts by mole of optional other chemical elements different from said three chemical elements,
wherein the parts by mole of the mixture add up to 1.00.

In embodiments outside the scope of the present invention, the mixture consists of:
at least 0.90 parts by mole of the composition of three or four chemical elements consisting of:
   from 0.25 to 0.55 parts by mole of Si,
   from 0.07 to 0.45 parts by mole of Te, and
   from 0.15 to 0.45 parts by mole of S, P, or a mixture of S and P, and
at most 0.10 parts by mole of the optional other chemical elements different from Si, Te, S, and P,

In embodiments, the mixture contains at most 0.07, preferably at most 0.05, more preferably at most 0.01, even more preferably at most 0.001, and most preferably no parts by mole of said optional other chemical elements different from said three chemical elements or of said optional other chemical elements different from S, P, Si, and Te. In embodiments, the optional other chemical elements different from said three chemical elements (or the optional other chemical elements different from S, P, Si, and Te) comprise at most one element present in an amount of from 0.05 parts by mole. In embodiments, the optional other elements different from said three chemical elements (or the optional other chemical elements different from S, P, Si, and Te) contain at most 0.02, preferably at most 0.01, more preferably at most 0.005, even more preferably at most 0.001, parts by mole of non-metallic and non-metalloid elements. Preferably, the mixture contains at most 0.02, preferably at most 0.01, more preferably at most 0.001, even more preferably at most more preferably at most 0.0001, parts by mole of arsenic and selenium, combined, amongst the optional other chemical elements different from said three chemical elements (or amongst the optional other chemical elements different from S, P, Si, and Te). It is an advantage of embodiments of the present invention that good ovonic threshold switches may be obtained without these toxic chemical elements, which are widely used for ovonic threshold switches of the state of the art. The optional other chemical elements different from said three chemical elements may be present as contaminants or may be present intentionally as their negative impact on the performances is typically acceptable. However, the amount of the optional other chemical elements different from said three chemical elements is, preferably, as low as possible, such as being not present at all, in which case a simple ternary mixture may be obtained with good properties for ovonic threshold switches.

In embodiments, the mixture is in a glass state, i.e., has a glass structure. Preferably, the mixture is in a glass state at a temperature of 25 °C and a pressure of 101325 Pa (1 atm). Preferably, the mixture has a glass transition temperature of at least 200°C, preferably at least 400°C, more preferably at least 600°C. In embodiments, the mixture is uniformly mixed. In embodiments, the mixture has an amorphous structure, e.g., at a temperature of 25 °C and a pressure of 101325 Pa (1 atm). In embodiments, the three chemical elements of the mixture, and, if present, the optional other chemical elements different from said three chemical elements are uniformly mixed throughout the mixture. Preferably, a temperature below which spinodal decomposition may occur for the mixture is at most 20 °C, preferably at most 10 °C, preferably at most 0 °C, at a pressure of 101325 Pa (1 atm). These embodiments may enable deposition of the ovonic threshold switch at a temperature of from room temperature, e.g., 25 °C, to about 100 °C, while limiting a risk of obtaining a non-uniform mixture.

In embodiments, the mixture contains an amount of Si in parts by mole, that is within 0.30, preferably within 0.20, parts by mole of an amount of Te or, when S is amongst the three chemical elements, a combined amount of Te and S, in parts by mole. The inventors have found that these mixtures may have good properties for ovonic threshold switches.

In embodiments outside the scope of the present invention, the composition of three chemical elements consists of from 0.30 to 0.60 parts by mole Si, from 0.10 to 0.50 parts by mole S, and from 0.05 to 0.40 parts by mole Te. In embodiments, the composition of three chemical elements consists of from 0.20 to 0.40 parts by mole Si, from 0.30 to 0.50 parts by mole Te, and from 0.20 to 0.40 parts by mole P. It is an advantage of these embodiments that good compositions may be obtained for ovonic threshold switches for memory elements and selector applications.

In embodiments, the composition of three chemical elements consists of from 0.30 to 0.60 parts by mole Si, from 0.20 to 0.50 parts by mole S, and from 0.05 to 0.40 parts by mole Te. It is an advantage of these embodiments that good compositions may be obtained for ovonic threshold switches for selector applications.

In embodiments, the device is a memory device. In embodiments, the memory device may comprise at least one electrically conductive row line, preferably a plurality of electrically conductive row lines. The conductive row line may comprise any conductive material, such as a metal or silicon. In embodiments, the memory device may comprise at least one electrically conductive column line, preferably a plurality of electrically conductive column lines. The conductive column line may comprise any conductive material, such as a metal or silicon. In embodiments, at least one row line and the at least one column line, e.g., each combination of a row line amongst the plurality of electrically conductive row lines and a column line amongst the plurality of electrically conductive row lines, may be electrically coupled to each other by a memory section, e.g., a stack, comprising the ovonic threshold switch.

In embodiments, the memory device, e.g., the memory section, e.g., the stack, further comprises a memory element electrically coupled in series with the ovonic threshold switch. Said electrical coupling may mean that the ovonic threshold switch physically contacts the memory element, or that the ovonic threshold switch is separated from the memory element by an electrically conductive material. In these embodiments, the ovonic threshold switch may function as a selector. In embodiments, the memory element may be switchable between a state with a high resistance and a state with a low resistance. For example, the memory element may be a resistive random-access memory element, a conductive random-access memory element or a phase-change memory element, preferably a phase-change memory element.

In embodiments, the memory device comprises a controller, e.g., a processor, connected to the row lines and the column lines. The controller may be configured for applying a writing voltage so as to switch a memory element from a first state to a second state, e.g., for writing data to the memory sections. In embodiments, the writing voltage is larger than a threshold voltage of the ovonic threshold switch, and smaller than twice a holding voltage of the ovonic threshold switch. The controller may further comprise a current detector, and the controller may be configured for applying a reading voltage so as to detect the current through the memory element. In embodiments, the reading voltage is larger than a threshold voltage of the ovonic threshold switch, and smaller than twice a holding voltage of the ovonic threshold switch.

In embodiments, the memory section comprises, or consists of, a memory element comprising the ovonic threshold switch. In these embodiments, information may be stored in the ovonic threshold switch itself. As a first, preferred, example, the threshold voltage of an ovonic threshold switch has been found to be slightly dependent on a polarity of a last applied pulse. Therefore, writing binary data into the ovonic threshold switch may be performed by applying one of two different pulses with different polarity. Herein, a first threshold voltage, resulting from a pulse having a first polarity, may be representative of binary 0, and a second threshold voltage, resulting from a pulse having a second polarity, opposite to the first polarity, may be representative of binary 1. To determine whether the ovonic threshold exhibits the first threshold voltage or the second threshold voltage, an intermediate voltage may be applied that is in between the first threshold voltage and the second threshold voltage, and a current through the ovonic threshold switch may be determined. In these embodiments, the controller may be configured for applying, when writing a first binary data bit, e.g., "1", to the ovonic threshold switch, a first voltage having a first polarity so as to set the ovonic threshold switch in a state having a first threshold voltage, and, when writing a second binary data bit different from the first binary data bit, e.g., "0", to the ovonic threshold switch, a voltage having a second polarity, different from, e.g., opposite to, the first polarity, so as to set the ovonic threshold switch in a state having a second threshold voltage. The controller may be further configured for, when reading data from the ovonic threshold switch, applying an intermediate voltage, in between the first and second threshold voltage, and detecting a current through the ovonic threshold switch. As a second example, use may be made of the bistability, due to hysteresis in the current-voltage curve, of the ovonic threshold switch. When a voltage is applied that is larger than the threshold voltage, the ovonic threshold switch is in a conductive state. When a voltage is applied that is below a holding voltage, the ovonic threshold switch is in a resistive state. When an intermediate voltage is applied that is between the holding voltage and the threshold voltage, the ovonic threshold switch is either in a conductive state or in a resistive state, depending on whether the voltage applied before the intermediate voltage was above the threshold voltage or below the holding voltage. Thus, binary data may be stored by first applying a voltage either above the threshold voltage or below the holding voltage, then applying the intermediate voltage. By detecting a current when the intermediate voltage is applied, the state of the ovonic threshold switch may be detected. In these embodiments, the controller may be configured for applying, when writing a first binary data bit, e.g., "1", to the ovonic threshold switch, a first voltage having a first voltage that is at most the holding voltage so as to set the ovonic threshold switch in a resistive state, and, when writing a second binary data bit different from the first binary data bit, e.g., "0", to the ovonic threshold switch, a second voltage that is at least the threshold voltage so as to set the ovonic threshold switch in a conductive state. The controller may be further configured for, when reading data from the ovonic threshold switch, applying an intermediate voltage and detecting a current through the ovonic threshold switch. It is an advantage of these embodiments that switching may be fast and energy consumption may be low.

In embodiments, the memory device may comprise at least one set, e.g., a plurality of sets, of a plurality of row lines, and a plurality of sets of a plurality of column lines. The at least one set, e.g., then plurality of sets, of a plurality of row lines and the plurality of sets of a plurality of column lines may be ordered alternatingly. Each combination of a row line from a set of a plurality of row lines and a column line from adjacent sets of a plurality of column lines may be electrically coupled to each other by a memory section comprising the ovonic threshold switch. As an example, a set of a plurality of column lines may be located between two sets of the plurality of row lines. In embodiments, each combination of a column line from the set of the plurality of column lines and a row line from a first set of the two sets of the plurality of row lines may be electrically coupled to each other by a memory section, e.g., a stack, comprising the ovonic threshold switch, and each combination of a column line from the set of the plurality of column lines and a row line from a second set, different from the first set, of the two sets of the plurality of row lines may be electrically coupled to each other by a memory section, e.g., a stack, comprising the ovonic threshold switch. It is an advantage of these embodiments that a dense memory device, sometimes called a three-dimensional cross-point memory device, may be obtained.

In embodiments, the device comprises an electrostatic discharge device comprising the ovonic threshold switch. In embodiments, the device comprises a semiconductor device. A first terminal of the electrostatic discharge device may be connected to the semiconductor device. A second terminal of the electrostatic discharge device may be connected to a voltage source or ground. In case of a build-up of a voltage in the semiconductor device, e.g., due to the semiconductor device being electrically contacted by an electrostatically charged person, the ovonic threshold switch of the electrostatic discharge device may switch from a resistive state to a conductive state, thereby providing a conduction path from the semiconductor device to the voltage source or the ground for release of the built-up voltage.

Any features of any embodiment of the first aspect may be independently as correspondingly described for any embodiment of the second aspect of the present invention.

In a second aspect, the present invention relates to a method for forming the device according to embodiments of the first aspect of the present invention, wherein forming the ovonic threshold switch comprises depositing a mixture on a substrate so as to form the mixture consisting of:
at least 0.90 parts by mole of a composition of three chemical elements consisting of:
   from 0.30 to 0.60 parts by mole of Si,
   from 0.05 to 0.40 parts by mole of Te, and
   from 0.15 to 0.50 parts by mole of S, and
at most 0.10 parts by mole of optional other chemical elements different from said three chemical elements,
wherein the parts by mole of the mixture add up to 1.00.

In embodiments, said depositing is performed by sputtering or atomic layer deposition. In embodiments, sputtering may be performed using AC sputtering or DC sputtering. In embodiments, three different sputtering targets may be used when sputtering, each target containing, e.g., formed of, a different amongst the three chemical elements. In embodiments, said depositing is performed at a temperature of at most 200 °C, for example, at most 100 °C. In embodiments, said depositing is performed at a temperature of at least 10 °C, for example, at least 20 °C.

Any features of any embodiment of the second aspect may be independently as correspondingly described for any embodiment of the first aspect of the present invention.

### Example 1: Memory device having an ovonic threshold switch as a selector

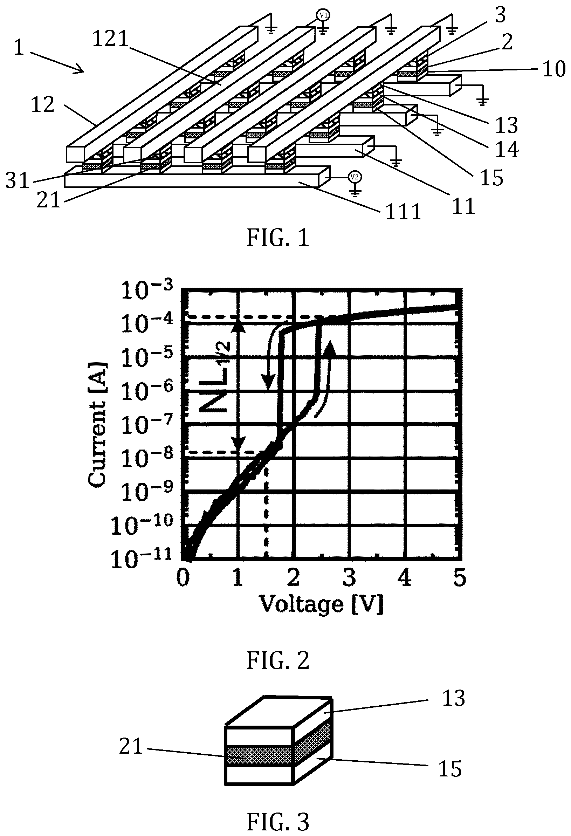

Reference is made to FIG. 1, which shows a memory device 1, comprising a selector that is an ovonic threshold switch, in accordance with embodiments of the present invention. The memory device 1 of this example comprises four parallel column lines 12 (forming the "bit line") and four parallel row lines 11 (forming the "word line"). The column lines 12 and the row lines 11 are typically conductive lines, e.g., silicon lines, connected to a controller for selectively and independently applying a voltage to the row lines 11 and the column lines 12. Each combination of a column line 12 and a row line 11 is electrically coupled to each other by a stack 10 comprising an ovonic threshold switch 2 in accordance with embodiments of the present invention, in series with a memory element 3, which is, in this example, a resistive memory element 3, more particularly, a phase-change memory element 3. In this example, each phase-change memory element 3 is electrically coupled to the respective ovonic threshold switch 2 via a middle electrode 14. However, this is not essential and instead, the phase-change memory element 3 may physically contact the ovonic threshold switch 2. In this example, each phase-change memory element 3 is electrically coupled to the respective column line 12 via a top electrode 13. However, the top electrode 13 is not essential, and instead, the phase-change memory element 3 may physically contact the column line 12. In this example, each ovonic threshold switch 2 is electrically coupled to the respective row line 11 via a bottom electrode 15. However, the bottom electrode 15 is not essential, and instead, the ovonic threshold switch 2 may physically contact the row line 11. The order of the ovonic threshold switch 2 and the phase-change memory element 3 within the stack 10 may be switched.

In the phase-change memory element 3, data may be stored in a binary system. For example, the phase-change memory element 3 may be reversibly switchable between a low-resistance crystalline state, e.g., representing binary "1", and a high-resistance amorphous state, e.g., representing binary "0". Switching between said low-resistance crystalline state and said high-resistance amorphous state may be performed by applying a writing voltage, which may (possibly in combination with a resistive element in series with and contacting the phase-change memory element - not shown) heat the phase-change memory element 3. Fast quenching of the heat may result in the phase-change memory element 3 ending up in the amorphous state, whereas a longer heating time and slow cooling down may result in the phase-change memory element 3 ending up in the crystalline state.

FIG. 1 represents a state wherein a first voltage V1 is applied to a specific column line 121 and a second voltage V2 is applied to a specific row line 111, and a ground voltage is applied to each other column line 12, different from the specific column line 121, and each other row line 11, different from the specific row line 111. Indeed, reading the data stored in each phase-change memory element 3 may be performed by applying a sensing potential between the column line 12 and the row line 11 connected by the phase-change memory element 3 to be read.

For example, for sensing a specific phase-change memory element 31, a first voltage V1 (e.g., of +1.5V, see below) may be applied to the specific column line 121. A second voltage V2 (e.g., of -1.5V, see below) may be applied to the specific row line 111. By sensing the current, the resistance, and thus the state, of the specific phase-change memory element 31 may be determined. In absence of the ovonic threshold switches 2, reading may result in leakage of the current via different phase-change memory elements 3 than the phase-change memory element 31 to be sensed, thereby complicating interpretation of the sensed current.

Reference is made to FIG. 2, which is an exemplary current-voltage plot for an ovonic threshold switch, obtained by applying a first voltage sweep from 0 V to 5 V, and subsequently, a second voltage sweep from 5 V to 0V, across the ovonic threshold switch, while determining the current through the ovonic threshold switch. As may be observed by the two different curves, for which a direction of the applied voltage sweep is indicated by the arrows, the ovonic threshold switch exhibits hysteresis. For this ovonic threshold switch, a threshold voltage, at which the ovonic threshold switch switches from a resistive state to a conductive state, is approximately 2.3 V. For this ovonic threshold switch, a holding voltage, wherein the ovonic threshold switch switches from a conductive state to a resistive state, is approximately 1.8 V. It may be observed that a flow of current through the ovonic threshold switch is orders of magnitude lower in the resistive state than in the conductive state. The difference in current at 3V and at 1.5V (i.e., at ½ × 3V) due to the nonlinear (NL) resistance of the ovonic threshold switch, is indicated by the double-arrow assigned with NL_{1/2}, which amounts to four orders of magnitude. For applications wherein the ovonic threshold switch is used as a selector, the current-voltage curve may be completely symmetric, i.e., independent of the polarity (that is, independent of the sign of the applied voltage) of the last applied pulse.

Thus, referring back to FIG. 1, in the present example, due to the presence of the ovonic threshold switches 2, current may flow unhindered through the specific ovonic threshold switch 21, connected in series with the specific phase-change memory element 31 that is to be sensed, as the voltage may be (V1 - V2 = ) 3V across the specific ovonic threshold switch 21 so that the specific ovonic threshold switch 21 may be in the conductive state. At the same time, current is blocked by all other ovonic threshold switches 2, connected in series with other phase-change memory elements 3 different from the specific phase-change memory element 31 that is to be sensed. Indeed, the voltage across the different ovonic threshold switches 3 connected to the same row line 11 or column line 12 as the phase-change memory element 3 to be sensed may be up to 1.5V, in which case these different ovonic threshold switches 3 are in the resistive state. As such, the ovonic threshold switches 2 function as a selector.

Although, in this example, the function of the ovonic threshold switch 2 has been explained for reading of the memory element 3, the ovonic threshold switch 2 has a similar function, hence similar advantages, for writing of the memory element 3.

Furthermore, although a specific memory device 1 has been described, different architectures may be envisaged.

### Example 2: Memory device having an ovonic threshold switch as a memory element

Instead of using a separate memory element 3 different from the ovonic threshold switch 2, the ovonic threshold switch 2 could be used itself as a memory element. In Example 1 above, the ovonic threshold switch is used as a selector, and the stack connecting each combination of a row line 11 and a column line 12 comprises both an ovonic threshold switch 21 and a memory element 31, e.g., a phase-change memory element 31 (cfr. FIG. 1).

Reference is made to FIG. 3. Instead, when an ovonic threshold switch 21 is used as a memory element in itself, a stack connecting each combination of a row line and a column line may comprise the ovonic threshold switch 21, a bottom electrode 15 electrically coupling the ovonic threshold switch 21 to the row line, and a top electrode 13 electrically coupling the ovonic threshold switch 21 to the column line. As in Example 3, however, neither the top electrode 13 nor the bottom electrode 15 are essential, and instead, the ovonic threshold switch 21 may directly contact the row line and the column line.

When the ovonic threshold switch 21 is used as the memory element, as indicated above in the description, the ovonic threshold switch 21 preferably has a threshold voltage that is dependent on a polarity of a last applied pulse. This polarity dependent threshold voltage may be used to store data in the ovonic threshold switch 21. Alternatively, as indicated above in the description, bistability typically exhibited by ovonic threshold switches 21 that is due to the hysteresis in the current-voltage curve (cfr. FIG. 2), may be used for storing information in the ovonic threshold switch 21.

### Selecting compositions for ovonic threshold switches for selector applications

The inventors took a systematic approach for searching for new, simple (e.g., ternary), compositions for ovonic threshold switches at the theoretical level. For this, ab initio calculations were performed on a range of ternary compositions, that are combinations of three chemical elements selected from the following chemical elements: B, C, N, Al, Si, P, S, Zn, Ga, Ge, In, Sn, Sb, and Te. Herein, for each combination of three chemical elements X, Y, and Z, calculations were performed on all compositions having the formula: XₓY_{y}Z_{z}, with values for subscripts x, y, and z each ranging from 0.1 to 0.8 in steps of 0.1 and with x+y+z = 1.

In a first step, amongst all assessed compositions, only those compositions were retained that were calculated to:
1. be stable in an amorphous phase at operating conditions, that is, have a glass transition temperature of at least 600 K;
2. have an average of 5±0.3 valence electrons/atom, which is a theoretical indicator of good properties for the composition functioning as an ovonic threshold switch;
3. have a negative energy of formation, i.e., will not decompose; and
4. exhibit a mobility gap of from 1.05 eV to 1.3 eV, and a trap gap of from 0.4 eV to 0.6 eV, indicative of a low electric leakage when in a resistive state, which may be preferred for applications of the ovonic threshold switch as a selector. The mobility gap is the difference in energy between the electrons in the conduction band and the holes in the valence band. The trap gap is the largest difference in the energy levels of the electron and hole traps in the material.

In a second step, for the compositions retained after the first step, an ovonic threshold switch (OTS) gauge was determined as an indicator of OTS behaviour, e.g., exhibiting a strong nonlinear resistance. The OTS gauge is based on Born charges.

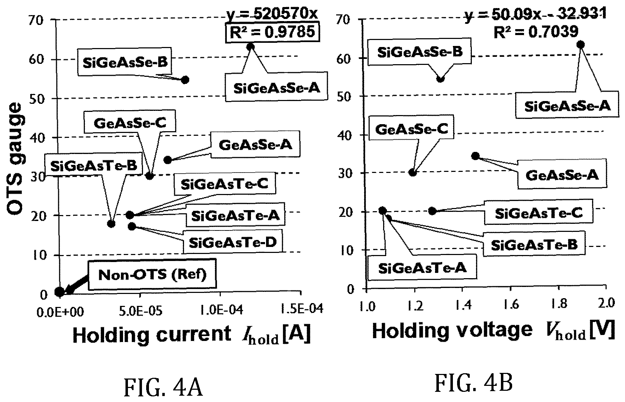

Reference is made to FIG. 4A and FIG. 4B. To assess the usefulness and accuracy of the thus defined OTS gauge, OTS gauges were determined for OTS materials of the state of the art (comprising arsenic and/or selenium), i.e., not part of the present invention, and compared with experimental holding voltages and experimental holding currents for these OTS materials. As may be observed in FIG. 4A and FIG. 4B, respectively, the calculated OTS gauge for these OTS materials were found to have a good correlation with experimental holding voltages and experimental holding currents. Said good correlation is clear from the fitted linear model and the calculated R² error thereof, indicated in the top right corner of FIG. 4A and FIG. 4B. In particular the correlation of the OTS gauge with the experimental holding current appears to be good. As such, the OTS gauge appears to be a good predictor of OTS functionality.

Only compositions retained after the first step having an OTS gauge of at least 18 were retained in the second step.

Additionally, for the retained compositions, the spinodal temperature T_{spinodal} was determined, based on a machine learning model. Since typical deposition temperatures of OTS materials are from room temperature (i.e., 25 °C to 100 °C), a T_{spinodal}, below which the composition is in a spinodal state, of at most 0 °C was imposed as a further screening condition. Hence, in the second step, only compositions having a T_{spinodal} < 0 °C were retained.

Table A summarizes three of the promising materials retained after the second step.

**Table A: For each composition retained for compositions for OTS for selector applications, this table summarizes: the OTS gauge; the spinodal temperature T_{spinodal}; the mobility gap E_{mobility}; the trap gap ΔEₜᵣₐₚ; the energy of formation E_{form}; the number of valence electrons per atom Nᵥₑ; and the glass transition temperature T_{g}.**

| **Composition** | **OTS gauge** | **T_{spinodal} (K)** | **E_{mobility} (eV)** | **AEtrap (eV)** | **Eform (eV/atom)** | **Nve** | **T_{g} (K)** |
|---|---|---|---|---|---|---|---|
| Si_{0.4}S_{0.3}Te_{0.3} | 34 | 0 | 1.17 | 0.45 | -0.37 | 5.2 | 728 |
| Si_{0.4}S_{0.4} Te_{0.2} | 31 | 0 | 1.27 | 0.48 | -0.53 | 5.2 | 784 |
| Si_{0.5}So_{0.4}Te_{0.1} | 26 | 0 | 1.14 | 0.60 | -0.52 | 5.0 | 868 |

### Selecting compositions for ovonic threshold switches for memory element applications

Above, the mobility gap and the trap gap were specifically selected for selector applications of the ovonic threshold switches. If, instead, the composition is to be used for ovonic threshold switches functioning as (stand-alone) memory elements, other values could be selected so as to obtain a lower or higher threshold voltage, as dependent on the specific memory specifications that is sought. In that case, the list of compositions of interest for the ovonic threshold switches may become longer. (For applications of compositions as ovonic threshold switches for electro-static discharge devices, where the windows for the mobility gap and the trap gap become even larger, the list may become even longer.)

For determining good compositions for ovonic threshold switches functioning as memory elements, in the first step described above, instead, a target window was set for the mobility gap of from 0.6 eV to 1.8 eV, and for the trap gap of from 0.1 eV to 0.6 eV. Again, in the second step, only compositions having a T_{spinodal} < 0 °C, and an OTS gauge of at least 18, were retained.

Table B summarizes two of the compositions with respective ranges that were retained.

**Table B: Summary of compositions retained for OTS for use as a memory element. The subscripts of the compositions indicate the range (with "x-y" meaning "from x to y") of the amount of each element in the composition, wherein the subscripts for each composition add up to 10.**

| **Composition** | **Largest OTS gauge within the range for the composition** |
|---|---|
| Si₄₋₅S₂₋₄Te₁₋₃ | 34 |
| Si₃P₃Te₄ | 29 |

It is to be understood that although preferred embodiments, specific constructions and configurations, as well as materials, have been discussed herein for devices according to the present invention, various changes or modifications in form and detail may be made without departing from the scope of this invention. Steps may be added or deleted to methods described within the scope of the present invention. The invention is defined by the appended claims.

## Claims

1. A device (1) comprising an ovonic threshold switch (2) formed of a mixture comprising Si and Te,
**characterized in that** the mixture consists of:
at least 0.90 parts by mole of a composition of three chemical elements consisting of:
from 0.30 to 0.60 parts by mole of Si,
from 0.05 to 0.40 parts by mole of Te, and
from 0.15 to 0.50 parts by mole of S, and
at most 0.10 parts by mole of optional other chemical elements different from said three chemical elements,
wherein the parts by mole of the mixture add up to 1.00.

2. The device (1) according to claim 1, wherein the mixture contains at most 0.07, preferably at most 0.05, parts by mole of said optional other chemical elements different from said three chemical elements.

3. The device (1) according to any of the previous claims, wherein the mixture is in a glass state at a temperature of 25 °C and a pressure of 101325 Pa (1 atm).

4. The device (1) according to any of the previous claims, wherein the mixture contains an amount of Si in parts by mole, that is within 0.30, preferably within 0.20, parts by mole of a combined amount of Te and S, in parts by mole.

5. The device (1) according to any of the previous claims, wherein the mixture is uniformly mixed.

6. The device (1) according to any of the previous claims, wherein the device (1) is a memory device (1).

7. The memory device (1) according to claim 6, further comprising a memory element (3) electrically coupled in series with the ovonic threshold switch (2).

8. The memory device according to claim 6, comprising a memory elemen (21) comprising the ovonic threshold switch.

9. A method for forming the device (1) according to any of the previous claims, wherein forming the ovonic threshold switch (2) comprises depositing a mixture on a substrate so as to form the mixture consisting of:
at least 0.90 parts by mole of a composition of three chemical elements consisting of:
from 0.30 to 0.60 parts by mole of Si,
from 0.05 to 0.40 parts by mole of Te,
from 0.15 to 0.50 parts by mole of S, and
at most 0.10 parts by mole of optional other chemical elements
different from said three chemical elements,
wherein the parts by mole of the mixture add up to 1.00.

10. The method according to claim 9, wherein said depositing is performed at a temperature of at most 200 °C, preferably at most 100 °C.

11. The method according to claim 9 or 10, wherein said depositing is performed using sputtering or atomic layer deposition.

## Patentansprüche

1. Eine Vorrichtung (1) die einen ovonischen Schwellenwertschalter (2) umfasst, der aus einem Gemisch gebildet ist, die Si und Te umfasst,
- **dadurch gekennzeichnet, dass** das Gemisch besteht aus:
- mindestens 0,90 Molteilen einer Zusammensetzung aus drei chemischen Elementen, bestehend aus:
- von 0,30 bis 0,60 Molteilen an Si,
- von 0,05 bis 0,40 Molteilen an Te, und
- von 0,15 bis 0,50 Molteilen an S, und
- höchstens 0,10 Molteilen an optionalen anderen chemischen Elementen, die sich von den drei chemischen Elementen unterscheiden,
- wobei die Molteile des Gemisches 1,00 ergeben.

2. Die Vorrichtung (1) nach Anspruch 1, wobei das Gemisch höchstens 0,07, vorzugsweise höchstens 0,05 Molteile der optionalen anderen chemischen Elemente enthält, die sich von den drei chemischen Elementen unterscheiden.

3. Die Vorrichtung (1) nach einem der vorstehenden Ansprüche, wobei das Gemisch bei einer Temperatur von 25 °C und einem Druck von 101325 Pa (1atm) in einem Glaszustand ist.

4. Die Vorrichtung (1) nach einem der vorstehenden Ansprüche, wobei das Gemisch eine Menge an Si in Molteilen enthält, die innerhalb von 0,30, vorzugsweise innerhalb von 0,20 Molteilen einer kombinierten Menge an Te und S in Molteilen liegt.

5. Die Vorrichtung (1) nach einem der vorstehenden Ansprüche, wobei das Gemisch einheitlich gemischt ist.

6. Die Vorrichtung (1) nach einem der vorstehenden Ansprüche, wobei die Vorrichtung (1) eine Speichervorrichtung (1) ist.

7. Die Speichervorrichtung (1) nach Anspruch 6, die weiter ein Speicherelement (3) umfasst, das elektrisch in Reihe mit dem ovonischen Schwellenwertschalter (2) gekoppelt ist.

8. Die Speichervorrichtung nach Anspruch 6, die ein Speicherelement (21) umfasst, das den ovonic-Schwellenwertschalter umfasst.

9. Ein Verfahren zum Bilden der Vorrichtung (1) nach einem der vorstehenden Ansprüche, wobei Bilden des ovonischen Schwellenwertschalters (2) umfasst
- Aufbringen eines Gemisches auf ein Substrat, um das Gemisch zu bilden, bestehend aus:
- mindestens 0,90 Molteilen einer Zusammensetzung aus drei chemischen Elementen, bestehend aus:
- von 0,30 bis 0,60 Molteilen an Si,
- von 0,05 bis 0,40 Molteilen an Te,
- von 0,15 bis 0,50 Molteilen an S, und
- höchstens 0,10 Molteilen an optionalen anderen chemischen Elementen, die sich von den drei chemischen Elementen unterscheiden,
- wobei die Molteile des Gemisches 1,00 ergeben.

10. Das Verfahren nach Anspruch 9, wobei das Abscheiden bei einer Temperatur von höchstens 200 °C, vorzugsweise höchstens 100 °C durchgeführt wird.

11. Das Verfahren nach Anspruch 9 oder 10, wobei das Abscheiden unter Verwendung von Sputtern oder Atomlagenabscheidung durchgeführt wird.

## Revendications

1. Un dispositif (1) comprenant un commutateur à seuil ovonique (2) formé d'un mélange comprenant du Si et du Te,
**caractérisé en ce que** le mélange consiste en :
au moins 0,90 partie en mole d'une composition de trois éléments chimiques consistant en :
de 0,30 à 0,60 partie en mole de Si,
de 0,05 à 0,40 partie en mole de Te, et
de 0,15 à 0,50 partie en mole de S, et
au plus 0,10 partie en mole d'autres éléments chimiques facultatifs différents desdits trois éléments chimiques,
dans lequel les parties en mole du mélange totalisent 1,00.

2. Le dispositif (1) selon la revendication 1, dans lequel le mélange contient au plus 0,07, de préférence au plus 0,05, partie en mole desdits autres éléments chimiques facultatifs différents desdits trois éléments chimiques.

3. Le dispositif (1) selon l'une quelconque des revendications précédentes, dans lequel le mélange est à l'état vitreux à une température de 25 °C et une pression de 101 325 Pa (1 atm).

4. Le dispositif (1) selon l'une quelconque des revendications précédentes, dans lequel le mélange contient une quantité de Si en parties en mole, qui est à moins de 0,30, de préférence à moins de 0,20, partie en mole d'une quantité combinée de Te et de S, en parties en mole.

5. Le dispositif (1) selon l'une quelconque des revendications précédentes, dans lequel le mélange est mélangé de manière uniforme.

6. Le dispositif (1) selon l'une quelconque des revendications précédentes, dans lequel le dispositif (1) est un dispositif de mémoire (1).

7. Le dispositif de mémoire (1) selon la revendication 6, comprenant en outre un élément de mémoire (3) couplé électriquement en série avec le commutateur à seuil ovonique (2).

8. Le dispositif de mémoire selon la revendication 6, comprenant un élément de mémoire (21) comprenant le commutateur à seuil ovonique.

9. Un procédé de formation du dispositif (1) selon l'une quelconque des revendications précédentes, dans lequel la formation du commutateur à seuil ovonique (2) comprend le dépôt d'un mélange sur un substrat de manière à former le mélange consistant en :
au moins 0,90 partie en mole d'une composition de trois éléments chimiques consistant en :
de 0,30 à 0,60 partie en mole de Si,
de 0,05 à 0,40 partie en mole de Te,
de 0,15 à 0,50 partie en mole de S, et
au plus 0,10 partie en mole d'autres éléments chimiques facultatifs différents desdits trois éléments chimiques,
dans lequel les parties en mole du mélange totalisent 1,00.

10. Le procédé selon la revendication 9, dans lequel ledit dépôt est effectué à une température d'au plus 200 °C, de préférence d'au plus 100 °C.

11. Le procédé selon la revendication 9 ou 10, dans lequel ledit dépôt est effectué en utilisant la pulvérisation cathodique ou le dépôt de couches atomiques.
